# EUROPÄISCHE PATENTSCHRIFT

(11) **EP 3 785 311 B1**
(45) Veröffentlichungstag und Bekanntmachung des Hinweises auf die Patenterteilung: **23.11.2022**
(21) Anmeldenummer: 19722001.5
(22) Anmeldetag: 16.04.2019
(51) Int. Cl.: H01M 50/503, H01M 50/517, H01M 50/522, H01R 12/51, H01R 4/34

(54) **VORRICHTUNG ZUM ELEKTRISCHEN KONTAKTIEREN EINER LEITERPLATTE AN EIN BATTERIEZELLENVERBUNDSYSTEM UND EINRICHTUNG MIT EINER DERARTIGEN VORRICHTUNG UND EINEM DERARTIGEN BATTERIEZELLENVERBUNDSYSTEM**
MECHANISM FOR ELECTRICALLY CONTACTING A PRINTED CIRCUIT BOARD TO A BATTERY CELL COMPOSITE SYSTEM, AND DEVICE COMPRISING SUCH A MECHANISM, AND SUCH A BATTERY CELL COMPOSITE SYSTEM
DISPOSITIF POUR LA MISE EN CONTACT ÉLECTRIQUE D'UNE CARTE DE CIRCUIT IMPRIMÉ À UN SYSTÈME D'ENSEMBLE DE CELLULES DE BATTERIE ET INSTALLATION COMPRENANT UN TEL DISPOSITIF ET UN TEL SYSTÈME D'ENSEMBLE DE CELLULES DE BATTERIE

(30) Priorität: 23.04.2018 DE 102018206231
(43) Veröffentlichungstag der Anmeldung: 03.03.2021
(73) Patentinhaber: Triathlon Batterien GmbH, 08371 Glauchau (DE)
(72) Erfinder: FUCHS, Viktor, 45892 Gelsenkirchen (DE); ZIMMERMANN, Uwe, 09350 Lichtenstein (DE)
(74) Vertreter: Rau, Schneck & Hübner Patentanwälte Rechtsanwälte PartGmbB
(86) Internationale Anmeldenummer: PCT/EP2019/059735
(87) Internationale Veröffentlichungsnummer: WO 2019/206730

(56) Entgegenhaltungen:
- WO-A1-2012/171071
- DE-T5-112015 005 087
- US-A1- 2011 081 568
- US-A1- 2016 093 863

## Beschreibung

Die vorliegende Patentanmeldung nimmt die Priorität der deutschen Patentanmeldung DE 10 2018 206 231.5 in Anspruch.

Die Erfindung betrifft eine Vorrichtung zum elektrischen Kontaktieren einer Leiterplatte an ein Batteriezellenverbundsystem sowie eine Einrichtung mit einer derartigen Vorrichtung und einem Batteriezellenverbundsystem. Es ist bekannt, dass Batteriezellen eines Batteriezellenverbundsystems mittels mindestens eines Zellverbinders verbunden sind. Derartige Batteriezellenverbundsysteme sind beispielsweise bekannt aus US 2016/0093863 A1, DE 11 2015 005 087 T5 und aus DE 10 2010 022 689 A1. US 2011/0081568 A1 offenbart ein Batteriemodul. WO 2012/171 071 A1 offenbart eine Adapterschnittstelle für eine elektrische Verbindung zwischen einer elektrischen Energiespeichereinheit und einem Stromleiter.

FR3047616 A3 offenbart ein Verbindungselement beinhaltend ein Al-Cu Bimetallelement und anstatt eines Außengewindes eine Niete, die festgeschweißt wird. Zur elektrischen Kontaktierung des Batteriezellenverbundsystems mit einer elektrischen Leiterplatte dienen Drahtlitzen, die an der Leiterplatte und an dem Zellverbinder beispielsweise mittels Schneid-Klemm-Technik oder durch eine Lötverbindung kontaktiert werden. Die elektrische Kontaktierung der Drahtlitze mit dem Zellverbinder kann mittels Reibschweißen erfolgen, wobei ein zusätzlicher Passivierungsschritt erforderlich ist, um die Atmosphäre, insbesondere die Luftfeuchte, zu isolieren. Das Kontaktierungsverfahren mit geschweißter Litze ist aufwändig und kostenintensiv.

Es ist eine Aufgabe der vorliegenden Verbindung, die elektrische Kontaktierung einer Leiterplatte an einem Batteriezellenverbundsystem zu verbessern, insbesondere die Herstellung der Kontaktierung zu vereinfachen und insbesondere die Kontaktierung selbst robust auszugestalten.

Diese Aufgabe ist erfindungsgemäß gelöst durch eine Vorrichtung mit den im Anspruch 1 angegebenen Merkmalen sowie durch eine Einrichtung mit den im Anspruch 10 angegebenen Merkmalen. Erfindungsgemäß wurde erkannt, dass ein an der Leiterplatte befestigtes Bimetallelement das elektrische Kontaktieren eines Zellverbinders vereinfacht. Die Herstellung der elektrischen Kontaktierung ist vereinfacht. Die elektrische Kontaktierung ist robust ausgestaltet.

Es wurde gefunden, dass die aufwändige Fertigung gemäß dem Stand der Technik im Wesentlichen damit begründet ist, dass verschiedene Materialien miteinander kontaktiert und verbunden werden müssen, insbesondere Kupfer, das für die Drahtlitze verwendet werden kann, und Aluminium, das für einen Zellverbinder verwendet werden kann. Das Bimetallelement ist ein Verbundbauteil aus mindestens zwei verschiedenen Materialien, nämlich aus Kupfer und Aluminium.

Das Bimetallelement weist eine erste Lage eines ersten Materials, Kupfer, und eine zweite Lage eines zweiten Materials, Aluminium, auf. Die beiden Materiallagen sind übereinander angeordnet. Die Materiallagen sind in Form von Ringscheiben ausgeführt. Die beiden Lagen sind zuverlässig miteinander verbunden und ermöglichen eine elektrische Kontaktierung der Lagen miteinander. Das Bimetallelement ist robust und insbesondere einteilig als Scheibe ausgeführt. Das Bimetallelement steht insbesondere als Halbzeug in Form eines Zukaufteils zur Verfügung.

Erfindungsgemäß wurde erkannt, dass das Bimetallelement eine vorteilhafte Kopplung der unterschiedlichen Materialien des Zellverbinders einerseits und die Anbindung an die Leiterplatte andererseits, insbesondere das Leitermaterial der Leiterplatte, das insbesondere Kupfer ist, ermöglicht. Die Verwendung einer Litze, insbesondere einer Kupferlitze, ist entbehrlich.

Die Leiterplatte umfasst insbesondere ein Trägermaterial, das auch als Substrat bezeichnet wird, das insbesondere von dem Leitermaterial an einer Oberfläche zumindest bereichsweise kaschiert ist. Das Leitermaterial ist Kupfer und insbesondere elektrisch und/oder thermisch leitend. Das Leitermaterial legt mindestens eine Leiterbahn auf einer äußeren Oberfläche der Leiterplatte an dem Trägermaterial fest.

Insbesondere weist die Leiterplatte mehrere Bimetallelemente auf, die an der Leiterplatte befestigt sind, insbesondere aufgelötet, angeschweißt und/oder eingepresst. Das Befestigen des Bimetallelements an der Leiterplatte kann insbesondere automatisiert erfolgen.

Über den Zellverbinder ist das Batteriezellenverbundsystem an die Leiterplatte, insbesondere an das Leitermaterial, angebunden. Es ist auch denkbar, dass mehrere Zellverbinder vorgesehen sind. Insbesondere ist jeweils ein Zellverbinder mit einem Bimetallelement kontaktiert. Dazu kann der Zellverbinder an dem Bimetallelement anliegen und/oder aufliegen. Der Zellverbinder weist ein Verbindungselement auf, das insbesondere integriert ausgeführt ist. Das Verbindungselement ist insbesondere fingerartig und insbesondere in Form einer Verbindungslasche ausgeführt.

Mittels eines Befestigungselements ist das Verbindungselement an dem mindestens einen Bimetallelement befestigt. Das Befestigungselement kann eine Schraube, insbesondere mit metrischem Außengewinde, sein. Als besonders vorteilhaft hat sich die Verwendung einer Schraube erwiesen, die einen Schraubenkopf mit einer vergrößerten Kontaktfläche aufweist. Insbesondere ist die Kontaktfläche an der Unterseite des Schraubenkopfes größer als die Kontaktfläche eines Sechskantschraubenkopfes einer metrischen Schraube. Dadurch wird eine verringerte Flächenpressung unter dem Schraubenkopf, insbesondere zwischen dem Schraubenkopf und dem Zellverbinder, ermöglicht. Insbesondere ist dadurch verhindert, dass unter dem Schraubenkopf eine plastische Materialdeformation, insbesondere des Zellverbinders, auftritt. Das ist insbesondere deshalb vorteilhaft, weil der Zellverbinder aus einem Material mit vergleichsweise geringer Härte, wie beispielsweise Reinaluminium, hergestellt sein kann. Dadurch, dass Beschädigungen der Oberfläche am Zellverbinder im Wesentlichen ausgeschlossen sind, ist die Korrosionssicherheit erhöht. Der große Durchmesser der Unterseite des Schraubenkopfes gewährleistet eine Kompensation von Toleranzen, insbesondere beim Abdecken von Langlöchern. Wegen der großen Kontaktfläche wird eine erhöhte wirksame Reibfläche zwischen dem Befestigungselement und dem Zellverbinder geschaffen, wodurch die Losdrehsicherheit, insbesondere bei einem automatisierten drehmomentkontrollierten Anziehen des Befestigungselements, erhöht ist. Insbesondere ist die Unterseite des Schraubenkopfes uneben ausgeführt. Beim Festdrehen der Schraube wird der scheibenartige Schraubenkopf elastisch deformiert und dadurch eine dauerhafte Vorspannung des Befestigungselements am Zellverbinder gewährleistet. Insbesondere sind zusätzliche Sicherungselemente, wie beispielsweise eine Feder und/oder ein Sprengring, entbehrlich. Ein vorteilhaft verwendetes Befestigungselement wird von dem Unternehmen Bossard AG unter der Marke ecosyn^{®} vertrieben.

Das Befestigungselement kann eine hochfeste Gewindebeschichtung aufweisen. Die Gewindebeschichtung weist eine hohe Temperaturbeständigkeit von - 60 °C bis 170 °C gemäß DIN 267-27 auf. Durch die Gewindebeschichtung kann die Gewindereibzahl eingestellt werden. Vorteilhafterweise beträgt die Gewindereibzahl zwischen 0,10 und 0,15. Das Einschraubdrehmoment ist durch die Beschichtung im Wesentlichen unverändert. Das Ausschraubdrehmoment ist erhöht. Insbesondere ist eine mit der Gewindebeschichtung beschichtete Schraube geeignet, Gegendrücke von bis zu 400 bar abzudichten. Die hochfeste Gewindebeschichtung ist zuverlässig als unverlierbarer Bestandteil des Gewindes des Befestigungselements ausgebildet. Die Gewindebeschichtung kann gemäß dem gezeigten Ausführungsbeispiel zusätzlich als Klebemasse dienen, die zusammen mit dem Befestigungselement eingeschraubt wird. Das so beschichtete Befestigungselement ist insbesondere für Anwendungen bei hohen Schock-Schwing-Anforderungen geeignet. Das Beschichtungsmaterial ist lackähnlich und lösungsmittelfrei. Es handelt sich um reaktive Beschichtungen auf Basis mikroverkapselter Acrylate zum Sichern und Dichten von Gewindeteilen. Das Beschichtungsmaterial ist trocken, grifffest und eignet sich für jede Art von Montageprozessen, insbesondere bei der Serienfertigung. Bei der Montage, also beim Eindrehen des Befestigungselements, werden Mikrokapseln, in welchen das Acrylat bevorraten ist, durch Druck und/oder Scherbeanspruchungen zerstört. Die freigesetzten Komponenten vermischen sich und härten bei der Montage aus.

Eine derartige, hochfeste Gewindebeschichtung wird beispielsweise von dem Unternehmen omniTECHNIK Mikroverkapselungs GmbH unter der Marke precote^{®} 85 angeboten.

Die Kontaktierung des Zellverbinders an dem Bimetallelement ist sichergestellt. Die Kontaktierung zwischen dem Zellverbinder und dem Bimetallelement ist robust. Die Verbindung und Kontaktierung von dem Bimetallelement an der Leiterplatte ist robust.

Eine Vorrichtung, bei der das Befestigungselement ein Befestigungsgewinde aufweist, ermöglicht eine definierte Befestigung des Verbindungselements an dem Bimetallelement. Insbesondere ist die Befestigung lösbar ausgeführt. Das Befestigen des Verbindungselements an dem Bimetallelement kann automatisiert durchgeführt werden. Das Einschrauben des Befestigungselements, das ein Befestigungsgewinde aufweist, kann in einem automatisierten Prozess beispielsweise mit einem definierten Eindreh-Drehmoment erfolgen. Dadurch ist eine Qualitätskontrolle während der Ausführung der Befestigung des Verbindungselements an dem Bimetallelement möglich.

Eine Ausführung des Bimetallelements mit einer Durchstecköffnung zum Durchstecken des Befestigungselements ermöglicht eine vereinfachte Verbindung mit dem Befestigungselement. Dadurch, dass das Bimetallelement eine Durchstecköffnung aufweist, kann das Befestigungselement ohne mechanischen Widerstand beim Befestigen durch das Bimetallelement durchgesteckt werden. Das Bimetallelement ist insbesondere scheibenartig, insbesondere in Form einer Ringscheibe und/oder in Form einer U-Scheibe ausgeführt.

Ein Gegenbefestigungselement, das mit dem Befestigungselement zusammenwirkt und ein Gegenbefestigungsgewinde aufweist, das mit dem Befestigungsgewinde des Befestigungselements zusammenwirkt, ermöglicht eine definierte und insbesondere mehrfach lösbare Befestigung des Verbindungselements an dem Bimetallelement. Als Gegenbefestigungselement dient insbesondere eine Mutter, die an der Leiterplatte, insbesondere an einer dem Bimetallelement gegenüberliegenden Unterseite, angebracht ist.

Die Ausführung des Gegenbefestigungselements gemäß Anspruch 4 ermöglicht einen robusten Fertigungsprozess, insbesondere bei der Verbindung des Zellverbinders an der Leiterplatte. Insbesondere ist das Gegenbefestigungselement an der Leiterplatte angeschweißt, aufgelötet und/oder eingepresst. Es ist auch denkbar, dass das Gegenbefestigungselement an der Leiterplatte lediglich fixiert ist, wobei die eigentliche Befestigung des Gegenbefestigungselements an der Leiterplatte durch die Befestigung an dem Befestigungselement, insbesondere durch die Verschraubung mit dem Befestigungsgewinde, das in das Gegenbefestigungsgewinde eingreift, erfolgt.

Alternativ zu einem zusätzlichen Gegenbefestigungselement kann die Befestigung des Befestigungselements auch unmittelbar in der Leiterplatte selbst erfolgen. Es ist denkbar, dass das Befestigungselement ein Befestigungsgewinde in Form eines Schneidgewindes aufweist, das unmittelbar zur mechanischen Befestigung in die Leiterplatte eingedreht wird. Um eine mechanische Beschädigung der Leiterplatte beispielsweise durch Reißen oder Springen zu vermeiden, kann die Leiterplatte vorgebohrt sein.

Die Anordnung des Verbindungselements gemäß Anspruch 5 vereinfacht die Befestigung an der Leiterplatte.

Die Ausführung des Verbindungselements gemäß Anspruch 6 gewährleistet eine ausreichende und elektrisch robuste Kontaktierung mit dem Bimetallelement.

Die Ausführung des Verbindungselements gemäß Anspruch 7 ermöglicht eine materialschonende und platzsparende Ausführung der Zellverbinder.

Die Ausführung des Verbindungselements gemäß Anspruch 8 ermöglicht eine vereinfachte, unmittelbare Befestigung des Befestigungselements.

Ein Tragrahmen gemäß Anspruch 9 dient zur mechanischen Stabilisierung der Vorrichtung.

Eine Einrichtung gemäß Anspruch 10 weist im Wesentlichen die Vorteile der Vorrichtung auf, worauf hiermit verwiesen wird. An der Vorrichtung können mehrere Batteriezellen, insbesondere Lithium-Ionen-Batterien, kontaktiert sein. Die Batteriezellen sind in einem Batteriezellenverbundsystem angeordnet und miteinander verbunden. Die Verbindung an die Leiterplatte der Vorrichtung erfolgt mittels der Zellverbinder. Die Batteriezellen können in Serie oder parallel in dem Batteriezellenverbundsystem verschalten sein.

Eine Einrichtung gemäß Anspruch 11 ermöglicht ein sicheres, zuverlässiges und gefahrloses Betreiben des Batteriezellenverbundsystems. Die Regelungseinheit weist insbesondere eine Steuerungselektronik auf, die insbesondere zur Spannungsmessung in den Batteriezellen, zur Temperaturmessung der Batteriezellen und/oder für einen Ladungsausgleich bei unterschiedlichen Ladezuständen der Batteriezellen dient.

Eine Einrichtung gemäß Anspruch 12 ist zusätzlich mechanisch stabilisiert.

Eine Einrichtung gemäß Anspruch 13 ermöglicht die Temperaturüberwachung, insbesondere an den Befestigungsstellen, also im Bereich der Bimetallelemente.

Eine Einrichtung gemäß Anspruch 14 ermöglicht eine Temperaturerfassung an den Zellpolen.

Ein Ausführungsbeispiel der Erfindung wird nachfolgend anhand der Zeichnung näher erläutert. In dieser zeigen:
- Fig. 1: eine Draufsicht einer Einrichtung mit einer erfindungsgemäßen Vorrichtung,

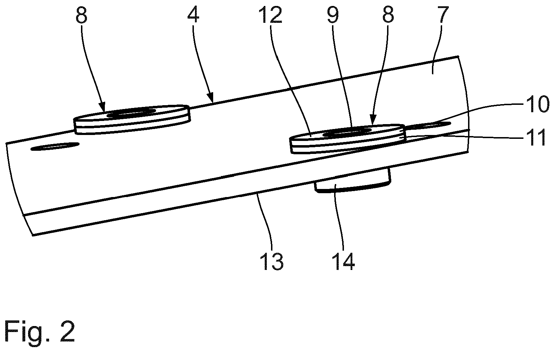

- Fig. 2: eine perspektivische Ansicht einer Leiterplatte der Vorrichtung ohne befestigte Zellverbinder, und
- Fig. 3: eine vergrößerte perspektivische Darstellung der Einrichtung mit einem mittels eines Befestigungselements an einem Bimetallelement befestigten Verbindungselement.

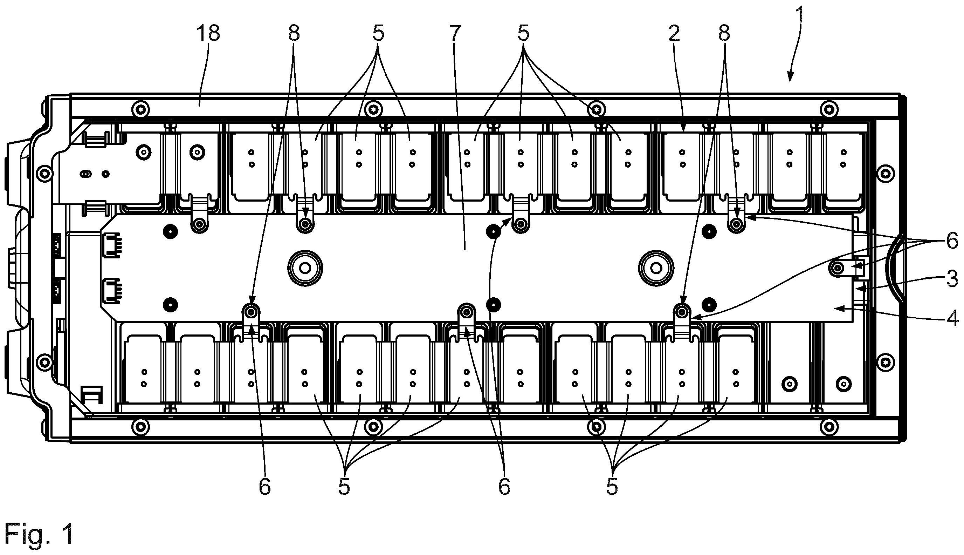

Eine in Fig. 1 als Ganzes mit 1 gekennzeichnete Einrichtung umfasst ein Batteriezellenverbundsystem 2 und eine insgesamt mit 3 gekennzeichnete Vorrichtung zum elektrischen Kontaktieren einer Leiterplatte 4 an das Batteriezellenverbundsystem 2.

Das Batteriezellenverbundsystem 2 weist mehrere Lithium-Ionen-Batteriezellen 5 auf, die jeweils mittels eines Zellverbinders 6 zusammengefasst und an der Leiterplatte 4 befestigt sind. Gemäß dem Ausführungsbeispiel sind acht Zellverbinder 6 vorgesehen, um die Batteriezellen 5 jeweils in Gruppen von beispielsweise vier Batteriezellen 5 zusammenzufassen und mit der Leiterplatte 4 zu verbinden, also elektrisch zu kontaktieren.

Das Batteriezellenverbundsystem 2 umfasst eine Regelungseinheit, die auf der Leiterplatte 4 integriert ist und insbesondere eine Steuerelektronik umfasst. Die Steuerelektronik kann insbesondere mit nicht dargestellten Temperatursensoren in Signalverbindung stehen, um eine thermische Belastung an der Leiterplatte 4 und insbesondere im Bereich der Zellverbinder 6 zu erfassen. Die Elektronik kann auch zum Ladungsausgleich der einzelnen Batteriezellen 5 dienen. Die Elektronik steht mit den Batteriezellen 5 in Signalverbindung.

Die Leiterplatte 4 umfasst ein Trägermaterial, insbesondere als Substrat, beispielsweise in Form eines Epoxidharzes, wobei das Trägermaterial mit einem Leitermaterial, gemäß dem gezeigten Ausführungsbeispiel Kupfer, zumindest bereichsweise kaschiert ist. Das Leitermaterial ist elektrisch und/oder thermisch leitend und bildet insbesondere Leiterbahnen an einer Oberfläche der Leiterplatte 4 aus.

Zur Befestigung der Zellverbinder 6 ist an einer in Fig. 1 dargestellten Oberseite 7 der Leiterplatte 4 ein Bimetallelement 8 für jeden der Zellverbinder 6 vorgesehen. Gemäß dem gezeigten Ausführungsbeispiel sind die Bimetallelemente 8 als Verbundbauteile ausgeführt. Die Bimetallelemente stellen eine integrale Verbindung von zwei unterschiedlichen Materialien, insbesondere von zwei unterschiedlichen Metallen dar. Gemäß dem gezeigten Ausführungsbeispiel sind die Bimetallelemente 8 als Kupfer-Aluminium-Verbundbauteile ausgeführt, die als Cupal-Elemente bezeichnet werden.

Gemäß dem gezeigten Ausführungsbeispiel sind die Bimetallelemente 8 jeweils als Ringscheiben ausgeführt mit einer Durchstecköffnung 9.

Das Bimetallelement 8 weist eine erste Aluminium-Lage 10 und eine damit verbundene Kupfer-Lage 11 auf. Das Bimetallelement 8 ist an der Leiterplatte 4 derart angeordnet und befestigt, dass die Kupfer-Lage 11 die Leiterplatte 4 und insbesondere das Leitermaterial der Leiterplatte 4 unmittelbar kontaktiert. Das Bimetallelement 8 ist an der Leiterplatte 4 aufgelötet, angeschweißt oder eingepresst. An einer der Leiterplatte 4 gegenüberliegenden Oberfläche der Kupfer-Lage 11 ist die Aluminium-Lage 10 angeordnet. Die Aluminium-Lage 10 dient zum Kontaktieren und Befestigen des Zellverbinders 6. An der der Leiterplatte 4 abgewandten Oberfläche weist das Bimetallelement 8 eine ringscheibenförmige Kontaktfläche 12 auf. Die Kontaktfläche 12 ist an der Aluminium-Lage 10 ausgeführt, insbesondere an der freien Oberfläche der Aluminium-Lage 10 angeordnet.

An der der Oberseite 7 der Leiterplatte 4 gegenüberliegenden Unterseite 13 ist ein dem Bimetallelement 8 korrespondierendes Gegenbefestigungselement 14 in Form einer Gewindehülse angeordnet. Das Gegenbefestigungselement 14 weist ein Innengewinde auf, insbesondere ein metrisches Innengewinde, das fluchtend zu der Durchstecköffnung 9 des Bimetallelements 8 angeordnet ist. Die Leiterplatte 4 weist eine korrespondierende, fluchtende Öffnung auf.

Die Gewindehülse 14 ist an der Unterseite 13 der Leiterplatte 4 zumindest fixiert und insbesondere befestigt, beispielsweise angeschweißt, aufgelötet und/oder eingepresst. Dadurch ist sichergestellt, dass sich das Gegenbefestigungselement 14 während des Fertigungsprozesses, also während des, Kontaktierens der Zellverbinder 6 an der Leiterplatte 4 nicht unbeabsichtigt löst. Die Gegenbefestigungselemente 14 sind während des Fertigungsprozesses zuverlässig an der Leiterplatte 4 gehalten.

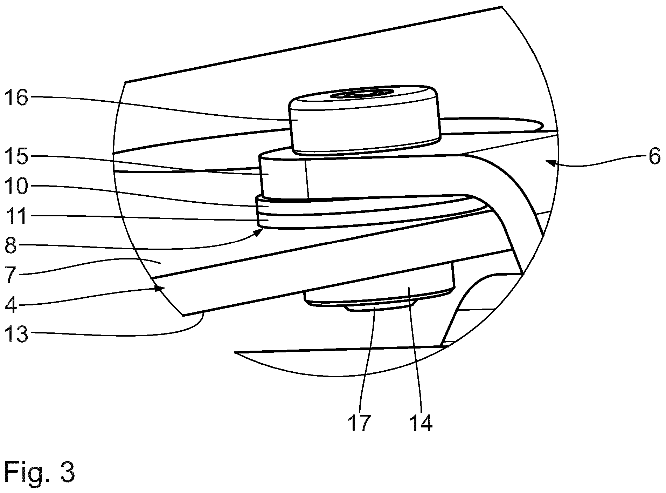

Wie in Fig. 3 dargestellt, weist der Zellverbinder 6 ein fingerförmiges, insbesondere laschenartiges Verbindungselement 15 auf. Das Verbindungselement 15 steht an einer Außenkante des Zellverbinders 6 vor und kann somit unmittelbar und unkompliziert mit der Leiterplatte 4 und dem dort angeordneten Bimetallelement 8 verbunden werden. Die Batteriezellen 5 sind im Wesentlichen seitlich in gegenüberliegend angeordneten Reihen an der Leiterplatte 4 angeordnet. Die Verbindungselemente 15 der Zellverbinder 6 ragen seitlich an der Leiterplatte 4 klammerartig über. Die Verbindungselemente 15 bilden eine zusätzliche Verbindungslage, die unmittelbar an dem Bimetallelement 8 aufliegen kann.

Zur Befestigung der Verbindungselemente 15 an den jeweiligen Bimetallelementen 8 dient ein Befestigungselement 16, das gemäß dem gezeigten Ausführungsbeispiel als metrische Schraube ausgeführt ist. Die Schraube weist ein mit dem Gegenverbindungselement 14 zusammenwirkendes Befestigungsgewinde 17 auf, das insbesondere als metrisches Außengewinde ausgeführt ist und in ein nicht dargestelltes metrisches Innengewinde des Gegenbefestigungselements 14 eingreift. Die Befestigung des Zellverbinders 6 über das Bimetallelement 8 an der Leiterplatte 4 ist unkompliziert und mechanisch robust. Insbesondere kann die Verbindung, insbesondere die elektrische Kontaktierung, wiederholgenau und automatisierbar durchgeführt werden. Die Fertigung einer derartigen Einrichtung, insbesondere die Befestigung des Batteriezellenverbundsystems 2 an der Leiterplatte 4, ist vereinfacht. Das Herstellverfahren ist robust und prozesssicher durchführbar.

Die elektrische Kontaktierung des Zellverbinders 6 mit dem Verbindungselement 15 aus Aluminium an der Aluminium-Lage 10 des Bimetallelements 8 ist dadurch verbessert. Die elektrische und thermische Kontaktierung innerhalb des Bimetallelements 8 ist gewährleistet. Die Kontaktierung des Bimetallelements 8 mit der Kupfer-Lage 11 an der Leiterplatte 4 ist prozesssicher und robust ausgeführt.

Die Leiterplatte 4 ist gemäß dem gezeigten Ausführungsbeispiel in einem Tragrahmen 18, insbesondere entlang ihres Umfangs, gehalten, also mechanisch fixiert. Der Tragrahmen 18 verleiht der Vorrichtung 3 eine zusätzliche mechanische Stabilität. Der Tragrahmen 18 kann auch dazu dienen, das Batteriezellenverbundsystem 2 zusätzlich zu halten und zu stabilisieren.

Durch die Kontaktierung des Zellverbinders 6 über das Bimetallelement 8 mit der Leiterplatte 4 ist die elektrische Verbindung definiert ausgeführt.

Dadurch, dass der Übergang von Aluminium auf Kupfer durch die Aluminium-Lage 10 und die Kupfer-Lage 11 in dem Bimetallelement 8 integriert ausgeführt ist, treten materialabhängige Probleme nicht auf. Insbesondere Korrosion zwischen den Materialien tritt nicht auf. Die Verbindung des Bimetallelements 8 an der Leiterplatte ist prozesssicher und massentauglich ausgeführt.

## Patentansprüche

1. Vorrichtung zum elektrischen Kontaktieren einer Leiterplatte (4) an ein Batteriezellenverbundsystem (2), wobei die Vorrichtung (3) aufweist
a. eine Leiterplatte (4), die als Leitermaterial Kupfer aufweist,
b. mindestens ein an der Leiterplatte (4) befestigtes Bimetallelement (8),
i. das als Verbundbauteil ausgeführt ist und eine Kupfer-Lage und eine Aluminium-Lage aufweist, die in Form von Ringscheiben ausgeführt sind, und
ii. das eine Durchstecköffnung (9) zum Durchstecken eines Befestigungselements (16) aufweist,
c. mindestens einen Zellverbinder (6) aus Aluminium zum Anbinden des Batteriezellenverbundsystem (2) an die Leiterplatte (4), wobei der Zellverbinder (6) mit einem Verbindungselement (15) das mindestens eine Bimetallelement (8) kontaktiert,
d. ein Befestigungselement (16) zum Befestigen des Verbindungselements (15) an dem mindestens einen Bimetallelement (8) , wobei das Befestigungselement (16) ein Befestigungsgewinde (17) aufweist,
e. ein mit dem Befestigungselement (16) zusammenwirkendes Gegenbefestigungselement (14), das ein Gegenbefestigungsgewinde aufweist, das mit dem Befestigungsgewinde (17) des Befestigungselements (16) zusammenwirkt.

2. Vorrichtung gemäß Anspruch 1, **dadurch gekennzeichnet, dass** das Befestigungsgewinde (17) ein Außengewinde und insbesondere ein metrisches Außengewinde aufweist.

3. Vorrichtung gemäß einem der vorstehenden Ansprüche, **dadurch gekennzeichnet, dass** das Gegenbefestigungsgewinde ein Innengewinde, insbesondere ein metrisches Innengewinde aufweist.

4. Vorrichtung gemäß einem der vorstehenden Ansprüche, **dadurch gekennzeichnet, dass** das Gegenbefestigungselement (14) an der Leiterplatte (4) befestigt ist.

5. Vorrichtung gemäß einem der vorstehenden Ansprüche, **dadurch gekennzeichnet, dass** das Verbindungselement (15), insbesondere an einer Außenkante des Zellverbinders (6), vorsteht.

6. Vorrichtung gemäß einem der vorstehenden Ansprüche, **dadurch gekennzeichnet, dass** das Verbindungselement (15) eine Verbindungsfläche aufweist, mit der das Verbindungselement (15) das mindestens eine Bimetallelement (8) kontaktiert.

7. Vorrichtung gemäß einem der vorstehenden Ansprüche, **dadurch gekennzeichnet, dass** das Verbindungselement (15) fingerartig ausgeführt ist.

8. Vorrichtung gemäß einem der vorstehenden Ansprüche, **dadurch gekennzeichnet, dass** das Verbindungselement (15) eine Durchgangsöffnung aufweist zum Durchführen des Befestigungselements (16).

9. Vorrichtung gemäß einem der vorstehenden Ansprüche, **gekennzeichnet durch** einen Tragrahmen (18), an dem die Leiterplatte (4), insbesondere entlang ihres Umfangs, gehalten ist.

10. Einrichtung mit
a. einer Vorrichtung (3) gemäß einem der vorstehenden Ansprüche,
b. einem mehrere Batteriezellen (5) aufweisenden Batteriezellenverbundsystem (2), das mittels des mindestens einen Zellverbinders (6) mit der Leiterplatte (4) verbunden ist.

11. Einrichtung gemäß Anspruch 10, **gekennzeichnet durch** eine Regelungseinheit, die insbesondere an dem Batteriezellenverbundsystem (2) angeordnet ist.

12. Einrichtung gemäß Anspruch 10 oder 11, **dadurch gekennzeichnet, dass** das Batteriezellenverbundsystem (2) an dem Tragrahmen (18) befestigt ist.

13. Einrichtung gemäß einem der Ansprüche 10 bis 12, **gekennzeichnet durch** mindestens einen Temperatursensor, der insbesondere benachbart zu dem mindestens einen Bimetallelement (8) angeordnet ist.

14. Einrichtung gemäß Anspruch 13, **dadurch gekennzeichnet, dass** der mindestens eine Temperatursensor an dem mindestens einen Bimetallelement (8) und an der Leiterplatte (4) befestigt ist.

## Claims

1. A mechanism for electrically contacting a printed circuit board (4) to a battery cell composite system (2), wherein the mechanism (3) has
a. a printed circuit board (4) which has copper as the conductor material,
b. at least one bimetallic element (8) which is fastened to the printed circuit board (4),
i. which is designed as a composite component and has a copper layer and an aluminium layer which are designed in the form of annular discs, and
ii. which has a through opening (9) for the plugging through a fastening element (16),
c. at least one cell connector (6) made of aluminium for connecting the battery cell composite system (2) to the printed circuit board (4), wherein the cell connector (6) contacts the at least one bimetallic element (8) with a connecting element (15),
d. a fastening element (16) for fastening the connecting element (15) to the at least one bimetallic element (8), wherein the fastening element (16) has a fastening thread (17),
e. a mating fastening element (14) cooperating with the fastening element (16) which has a mating fastening thread which cooperates with the fastening thread (17) of the fastening element (16).

2. The mechanism as claimed in claim 1, **characterized in that** the fastening thread (17) has an external thread and in particular a metric external thread.

3. The mechanism as claimed in one of the preceding claims, **characterized in that** the mating fastening thread has an internal thread, in particular a metric internal thread.

4. The mechanism as claimed in any one of the preceding claims, **characterized in that** the mating fastening element (14) is fastened to the printed circuit board (4).

5. The mechanism as claimed in one of the preceding claims, **characterized in that** the connecting element (15) protrudes, in particular at an outer edge of the cell connector (6).

6. The mechanism as claimed in any one of the preceding claims, **characterized in that** the connecting member (15) has a connecting surface by means of which the connecting element (15) contacts the at least one bimetallic element (8).

7. The mechanism as claimed in one of the preceding claims, **characterised in that** the connecting element (15) is finger-like in design.

8. The mechanism as claimed in any one of the preceding claims, **characterized in that** the connecting element (15) has a through-opening for the fastening element (16) to pass through.

9. The mechanism as claimed in one of the preceding claims, **characterized by** a supporting frame (18) on which the printed circuit board (4) is held, in particular along its periphery.

10. A device having
a. a mechanism (3) as claimed in one of the preceding claims,
b. a battery cell composite system (2) which has a plurality of battery cells (5) and which is connected to the printed circuit board (4) by means of the at least one cell connector (6).

11. The device as claimed in claim 10, **characterized by** a control unit which is arranged in particular at the battery cell composite system (2).

12. The device as claimed in claim 10 or 11, **characterized in that** the battery cell composite system (2) is fastened to the supporting frame (18).

13. The device as claimed in one of claims 10 to 12, **characterized by** at least one temperature sensor which is arranged in particular adjacent to the at least one bimetallic element (8).

14. The device as claimed in claim 13, **characterized in that** the at least one temperature sensor is fastened to the at least one bimetallic element (8) and to the printed circuit board (4).

## Revendications

1. Dispositif pour la mise en contact électrique d'une carte imprimée (4) avec un système composite de cellules de batterie (2), dans lequel le dispositif (3) présente
a. une carte imprimée (4) qui présente du cuivre comme matériau conducteur,
b. au moins un élément bimétallique (8) fixé à la carte imprimée (4),
i. qui est un élément composite présentant une couche de cuivre et une couche d'aluminium réalisées sous forme de disques annulaires, et
ii. qui présente une ouverture de passage (9) pour le passage d'un élément de fixation (16),
c. au moins un connecteur de cellule (6) en aluminium pour relier le système composite de cellules de batterie (2) à la carte imprimée (4), dans lequel le connecteur de cellule (6) est en contact avec ledit au moins un élément bimétallique (8) par un élément de liaison (15),
d. un élément de fixation (16) pour fixer l'élément de liaison (15) à l'au moins un élément bimétallique (8), dans lequel l'élément de fixation (16) présente un filetage de fixation (17),
e. un élément de fixation complémentaire (14) coopérant avec l'élément de fixation (16), qui présente un contre-filetage de fixation qui coopère avec le filetage de fixation (17) de l'élément de fixation (16).

2. Dispositif selon la revendication 1, **caractérisé en ce que** le filetage de fixation (17) présente un filetage extérieur et en particulier un filetage extérieur métrique.

3. Dispositif selon l'une quelconque es revendications précédentes, **caractérisé en ce que** le contre-filetage de fixation comporte un filetage intérieur, en particulier un filetage intérieur métrique.

4. Dispositif selon l'une quelconque des revendications précédentes, **caractérisé en ce que** l'élément de fixation complémentaire (14) est fixé à la carte imprimée (4).

5. Dispositif selon l'une quelconque des revendications précédentes, **caractérisé en ce que** l'élément de liaison (15) fait saillie, en particulier sur un bord extérieur du connecteur de cellule (6).

6. Dispositif selon l'une quelconque des revendications précédentes, **caractérisé en ce que** l'élément de liaison (15) présente une surface de liaison avec laquelle l'élément de liaison (15) entre en contact avec ledit au moins un élément bimétallique (8).

7. Dispositif selon l'une quelconque des revendications précédentes, **caractérisé en ce que** l'élément de liaison (15) est réalisé en forme de doigt.

8. Dispositif selon l'une quelconque des revendications précédentes, **caractérisé en ce que** l'élément de liaison (15) présente une ouverture de passage pour le passage de l'élément de fixation (16).

9. Dispositif selon l'une quelconque des revendications précédentes, **caractérisé par** un cadre support (18) sur lequel est maintenu la carte imprimée (4), en particulier le long de sa périphérie.

10. Installation avec
a. un dispositif (3) selon l'une quelconque des revendications précédentes,
b. un système composite de cellules de batterie (2) présentant plusieurs cellules de batterie (5), qui est relié à la carte imprimée (4) au moyen dudit au moins un connecteur de cellule (6).

11. Installation selon la revendication 10, **caractérisé par** une unité de régulation qui est disposée en particulier sur le système composite de cellules de batterie (2).

12. Installation selon la revendication 10 ou 11, **caractérisé en ce que** le système composite de cellules de batterie (2) est fixé au cadre support (18).

13. Installation selon l'une quelconque des revendications 10 à 12, **caractérisé par** au moins un capteur de température, qui est disposé en particulier au voisinage dudit au moins un élément bimétallique (8).

14. Installation selon la revendication 13, **caractérisé en ce que** ledit au moins un capteur de température est fixé audit au moins un élément bimétallique (8) et à ladite carte imprimée (4).
